Europäisches Patentamt

(19) European Patent Office

Office européen des brevets

(11) Publication number: **0 025 040**
**B1**

(12) **EUROPEAN PATENT SPECIFICATION**

(45) Date of publication of patent specification: **16.02.83**

(51) Int. Cl.³: **B 22 F 3/12, C 22 C 1/04**

(21) Application number: **80900430.2**

(22) Date of filing: **26.02.80**

(86) International application number:
**PCT/SE80/00051**

(87) International publication number:
**WO 80/01769 04.09.80 Gazette 80/20**

(54) A PROCESS FOR PRODUCING A PART BY POWDER METALLURGY METHODS.

(30) Priority: **26.02.79 SE 7901678**

(43) Date of publication of application:
**18.03.81 Bulletin 81/11**

(45) Publication of the grant of the patent:
**16.02.83 Bulletin 83/7**

(84) Designated Contracting States:
**FR**

(56) References cited:
   **CH - A - 181 590**
   **DE - B - 1 024 250**
   **DE - C - 866 097**
   **GB - A - 435 754**
   **GB - A - 600 066**
   **GB - A - 1 115 433**
   **GB - A - 1 214 355**
   **GB - A - 1 310 385**
   **GB - A - 1 472 479**
   **SE - B - 300 315**
   **SE - B - 307 819**
   **SE - C - 87 859**
   **US - A - 3 343 952**

(73) Proprietor: **JOHANNESSON, Thomas**
**Ekdalsvägen 8**
**S-582 69 Linköping (SE)**

(72) Inventor: **JOHANNESSON, Thomas**
**Ekdalsvägen 8**
**S-582 69 Linköping (SE)**

(74) Representative: **Du Chaffaut, François et al,**
**c/o Cabinet Harlé & Phélip 21, rue de la**
**Rochefoucauld**
**F-75009 Paris (FR)**

Courier Press, Leamington Spa, England

## A process for producing a part by powder metallurgy methods

The present invention relates to a process for producing a part by powder metallurgy methods, whereby a basic porous blank, or "green" preform, is produced, which is compressed by isostatic hot-pressing or forging in a tool and is shaped into the required part, and where, before the hot-pressing or forging, the green preform is exposed in a CVD (Chemical Vapour Deposition) process to a gas mixture which, when it strikes the surface of the green preform, deposits on the latter and in its pores a layer of a hard material which endows the finished part with a wear-resistant surface.

Powder metallurgy has made it possible to produce parts made, for example, of steel, with a high degree of dimensional precision, in large batches at low cost. The motor industry, for example, is an important user of powder metallurgy produced parts. In a known way, the wear-resistance of the parts can be increased by subjecting them to a hardening and annealing process. However, there is a risk that the shape of the parts will change during such processes. Changes in shape entail rejects or the expense of aligning or correcting the parts, which in turn means a higher price per part for fault-free parts.

The aim of the present invention is to provide a process for producing parts by powder metallurgy methods, by means of which the parts receive an increased wear-resistance without hardening or annealing, and this is made possible due to the fact that the process has the characteristics listed in the attached Claims.

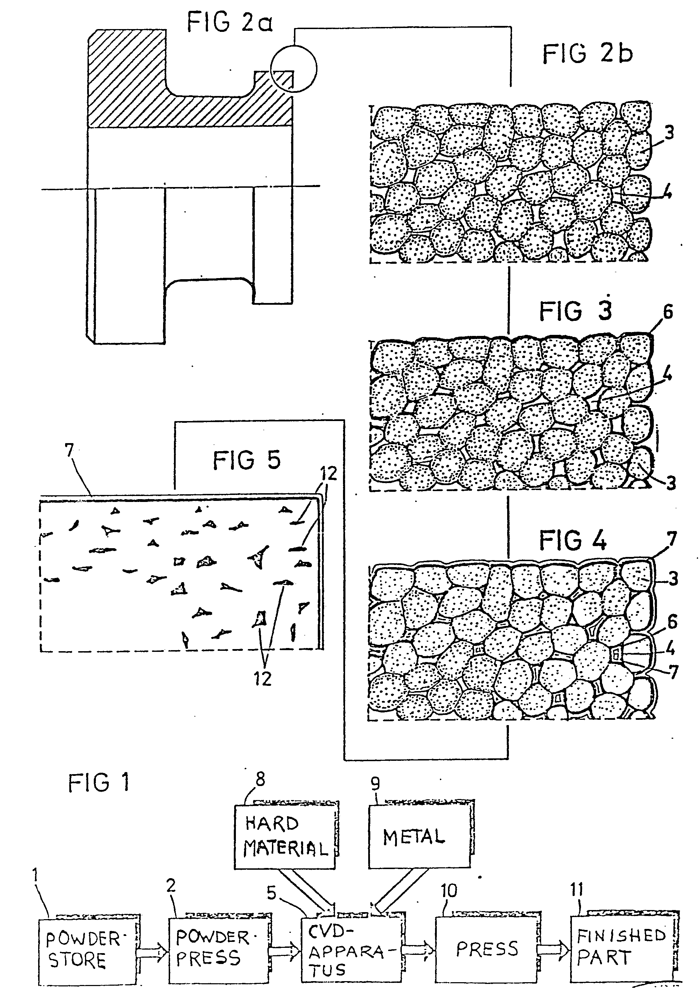

The invention will be explained in more detail in the following, with reference to the attached Drawing, on which Figure 1 is a block diagram showing the sequence of process steps which follow on after each other when the invention is applied. Figure 2a shows an example of a green preform, and Figure 2b shows schematically the micro-structure of a section through part of the green preform shown in Figure 2a. Figure 3 shows a cross-section through part of the green preform after its surface has been exposed to a gas mixture by means of which a hard material is deposited on and in at least the outermost surface layer of the green preform. In Figure 4, the part in Figure 3 is shown after exposure to a gas mixture which deposits on the green preform a material which is softer than the said hard material, such as a metal or a metal alloy, for example. Figure 5 shows schematically the microstructure of the finished part.

In Figure 1 the double-line arrows indicate the flow of materials between various stations, in which 1 symbolises a powder store which, for the sake of simplicity, will be assumed to contain powdered iron, and 2 is a powder press by means of which the iron powder is compressed into a shape to produce a green preform (see Figure 2a). The iron powder is chosen having regard to the desired properties of the finished part, such as high toughness, for example. The green preform is given a shape during pressing which resembles the shape of the finished part, but preferably has a porous micro-structure as shown in Figure 2b, where the separate grains of powder 3 and the spaces between them, the pores 4, can be seen.

So that, according to the invention, the part may be endowed with increased wear-resistance, the green preform is conveyed to a CVD plant (Chemical Vapour Deposition), where the green preform is exposed to a gas mixture which deposits on the surface of the green preform and in its pores 4 a layer 6 of a hard material, such as titanium carbide, for example, as shown in Figure 3.

If now the green preform is converted into the required part as described in the introduction, by isostatic pressing or forging, it will certainly have inclusions of hard material in its surface layer which will increase the wear-resistance of the part, but at the same time these will wear the equipment used during the shaping to an unacceptable extent.

According to the invention, therefore, the CVD process is carried out in two stages. After a layer of hard material has been deposited, the composition of the gas is changed so that a layer 7 of a softer material than the hard material is deposited on top of the layer 6, see Figure 4. Preferably, the softer metal is the same kind as the metal powder in the green preform. In Figure 1 the supply of the hard material and the metal or metal alloy to the CVD process are indicated by the two blocks 8 and 9 respectively. As is known, supply is effected by means of a gas mixture from which the hard material or the metal or metal alloy respectively are deposited.

After the layer 7 has been deposited the green preform is ready to be shaped in a press 10 into the desired part 11 by isostatic hot-pressing or forging. The layer 6 of hard material is shattered during pressing and forms inclusions 12 in the surface region of the finished part, while the softer layer 7 acts as a casing or protective layer which reduces the wear on the equipment.

The inclusions 12 increase the wear-resistance of the part. In certain cases the softer layer 7 can be discerned in the micro-structure of the part, as shown in Figure 5, but in other cases, during the pressing or forging process it dissolves into the basic material. For certain applications it may be expedient to remove the softer material from the surface of the part.

**Claims**

1. A process for producing a part by powder metallurgy methods, whereby a basic porous blank, or "green" preform, is produced, which is compressed by isostatic hot-pressing or forging in a tool and is shaped into the required part, and where, before the hot-pressing or forging, the green preform is exposed in a CVD (Chemical Vapour Deposition) process to a gas mixture which, when it strikes the surface of the green preform, deposits on the latter and in its pores a layer (6) of a hard material which endows the finished part with a wear-resistant surface, characterized in that after the hard material has been deposited but before hot-pressing or forging are carried out, the green preform is exposed in the CVD process to a gas mixture which deposits on top of the layer of hard material a layer (7) of metal or an alloy of metals which is softer than the hard material.

2. A process according to Claim 1, characterized in that the metal in the softer layer (7) is of the same kind as the material of the green preform.

3. A process according to Claim 1, characterized in that the softer layer (7) of metal or metal alloy is removed after hot-pressing or forging.

**Patentansprüche**

1. Verfahren zur Herstellung eines Teils mittels Pulvermetallurgie-Methoden, bei dem ein die Basis bildender poröser Rohling oder "grüner" Vorformling erzeugt wird, der durch isostatisches Heißpressen oder Schmieden in einem Werkzeug komprimiert und zu dem benötigten Teil geformt wird, und bei dem vor dem Heißpressen oder Schmieden der grüne Vorformling in einem Verfahren des chemischen Aufdampfens (CVD) einer Gasmischung ausgesetzt wird, die beim Auftreffen auf die Oberfläche des grünen Vorformlings auf dieser und in dessen Poren eine Schicht (6) eines harten Materials ablagert, die das fertige Teil mit einer verschleißfesten Oberfläche ausstattet, dadurch gekennzeichnet, daß nach der Ablagerung des harten Materials, jedoch vor der Durchführung des Heißpressens oder Schmiedens, der grüne Vorformling in dem Verfahren des chemischen Aufdampfens (CVD) einer Gasmischung ausgesetzt wird, die auf der Schicht des harten Materials eine Schicht (7) aus Metall oder einer Metallegierung ablagert, die weicher ist als das harte Material.

2. Verfahren nach Anspruch 1, dadurch gekennzeichnet, daß das Metall in der weicheren Schicht (7) von der gleichen Art ist wie das Material des grünen Vorformlings.

3. Verfahren nach Anspruch 1, dadurch gekennzeichnet, daß die weichere Schicht (7) aus Metall oder einer Metallegierung nach dem Heißpressen oder Schmieden entfernt wird.

**Revendications**

1. Procédé d'obtention d'une pièce par des processus de la métallurgie des poudres, suivant lequel une ébauche poreuse de base ou préforme "crue" est produite, puis est comprimée par compression isostatique à chaud ou forgeage dans un outil et est profilée à la forme de la pièce requise et suivant lequel, avant la compression à chaud ou forgeage, la préforme crûe est exposée dans un processus DVC (dépôt par vapeur chimique) à un mélange gazeux qui, lorsqu'il arrive sur la surface de la préforme crue, dépose sur vette dernière et dans ses pores une couche (6) d'une matière dure qui donne à la pièce finie une surface résistante à l'usure, caractérisé en ce que, après que la matière dure a été déposée mais avant la compression à chaud ou le forgeage, la préforme crue est exposée dans le processus DVC à un mélange gazeux qui dépose sur la partie supérieure de la couche de matière dure une couche (7) d'un métal ou d'un alliage métallique qui est plus tendre que la matière dure.

2. Procédé selon la revendication 1, caractérisé en ce que le métal de la couche plus tendre (7) est de la même nature que la matière de la préforme crue.

3. Procédé selon la revendication 1, caractérisé en ce que la couche plus tendre (7) de métal ou d'alliage métallique est enlevée après compression à chaud ou forgeage.

FIG 2a

FIG 2b

3

4

FIG 3

6

4

3

FIG 5

7

12

12

12

FIG 4

7

3

6

4

7

FIG 1

8

HARD MATERIAL

9

METAL

1

POWDER STORE

2

POWDER PRESS

5

CVD-APPARA-TUS

10

PRESS

11

FINISHED PART